# EUROPEAN PATENT SPECIFICATION

(11) **EP 3 046 141 B1**
(45) Date of publication and mention of the grant of the patent: **05.07.2017**
(21) Application number: 14844691.7
(22) Date of filing: 10.09.2014
(51) Int. Cl.: H01L 21/66, G01N 21/64, G01N 22/00

(54) **EVALUATION DEVICE FOR OXIDE SEMICONDUCTOR THIN FILM**
AUSWERTUNGSVORRICHTUNG FÜR OXIDHALBLEITERDÜNNSCHICHT
DISPOSITIF D'ÉVALUATION D'UNE COUCHE MINCE D'OXYDE SEMI-CONDUCTEUR

(30) Priority: 13.09.2013 JP 2013190402
(43) Date of publication of application: 20.07.2016
(73) Proprietor: Kabushiki Kaisha Kobe Seiko Sho (Kobe Steel, Ltd.), Kobe-shi, Hyogo 651-8585 (JP)
(72) Inventor: HAYASHI, Kazushi, Hyogo 651-2271 (JP); KISHI, Tomoya, Hyogo 651-2271 (JP)
(74) Representative: TBK
(86) International application number: PCT/JP2014/073865
(87) International publication number: WO 2015/037596

(56) References cited:
- WO-A1-2011/017772
- WO-A1-2012/070676
- JP-A- 2010 123 872
- JP-A- 2012 033 857
- JP-A- 2012 033 857
- US-A1- 2011 092 016
- TOMOYA KISHI ET AL.: 'Sankabutsu Handotai no Denkiteki, Kogakuteki Tokusei Hyoka (I) -Cathodoluminescence ni yoru Denshi Jotai no Process Izonsei' 2012 NEN SHUNKI DAI 59 KAI OYO BUTSURIGAKU KANKEI RENGO KOENKAI 'KOEN YOKOSHU' [ DVD -ROM], THE JAPAN SOCIETY OF APPLIED PHYSICS 29 February 2012, pages 21 - 078, XP008179811

## Description

### TECHNICAL FIELD

The present invention relates to an evaluation device for an oxide for a semiconductor layer (hereinafter, referred to as an "oxide semiconductor thin film") of a Thin Film Transistor (TFT) used in a display device such as liquid crystal display and organic EL display. More specifically, it relates to a device for contactlessly evaluating the mobility and stress stability of an oxide semiconductor thin film.

### BACKGROUND ART

An amorphous oxide semiconductor thin film has a high carrier mobility and a high optical bandgap and can be deposited at a low temperature, compared with widely-used amorphous silicon (hereinafter referred to as "a-Si"). Therefore, its application, for example, to a next-generation display which is required to have large size, high resolution and high-speed driving, or to a resin substrate with low heat resistance is expected.

Among oxide semiconductor thin films, in particular, an amorphous oxide semiconductor thin film containing at least one member of indium (In), gallium (Ga), zinc (Zn), tin (Sn), etc., such as In-Ga-Zn-O and In-Ga-Zn-Sn-O, has a very high carrier mobility and therefore, is favorably used for TFT.

However, as for an oxide semiconductor thin film, the mobility of the oxide semiconductor may vary due to a lattice defect produced in the deposition process or an impurity such as hydrogen in the film, to adversely affect the TFT properties.

In addition, the oxide semiconductor thin film has a problem that as compared with a case of using a-Si, the electrical properties are likely to fluctuate and the reliability is low. For example, in an organic EL display, a positive voltage is continuously applied to a gate electrode of a driving TFT during light emission of an organic EL device, and due to the voltage application, an electric charge is trapped at an interface between a gate insulating film and a semiconductor layer, giving rise to a problem that a threshold voltage (hereinafter, referred to as "Vth") is changed to change the switching properties.

Therefore, in the production process of a display device, etc., from the standpoint of enhancing the productivity, it is important to exactly measure or estimate the mobility or the amount of threshold voltage shift (hereinafter, referred to as "ΔVth") of a deposited oxide semiconductor thin film, evaluate the properties of the oxide semiconductor thin film, feedback the results, and adjust the production conditions, whereby the quality control of the film quality is performed.

As the method for characteristic evaluation of an oxide semiconductor thin film, usually the properties such as mobility and threshold value are measured after a gate insulating film or a passivation insulating film is formed on the oxide semiconductor thin film and an electrode is attached thereto. However, in the contact-type characteristic evaluation method requiring electrode attachment, the attachment of an electrode takes time and cost. Formation of the contact electrodes is also liable to induce additional defects in the oxide semiconductor thin film. From the standpoint of, for example, improving the production yield, a contactless-type characteristic evaluation method not requiring electrode attachment is demanded.

As a method for contactlessly evaluating the mobility of an oxide semiconductor thin film without electrode attachment, the present applicant has disclosed, as described in Patent Document 1, an evaluation method by a microwave photoconductivity decay method, and an evaluation device for use in the evaluation method. This is a technique where a sample having formed thereon an oxide semiconductor thin film is irradiated with a laser, a change in the microwave reflectance varying according to excess carriers excited by the laser irradiation is measured, and the lifetime value is then calculated, whereby the mobility of the oxide semiconductor thin film is evaluated.

### RELATED ART

### PATENT DOCUMENT

Patent Document 1: JP-A-2012-033857
Prior art which is related to this field of technology can be found e.g. in document WO 2011/017772 A1 disclosing a detection of discontinuities in semiconductor materials.

### SUMMARY OF THE INVENTION

### PROBLEMS THAT THE INVENTION IS TO SOLVE

In the technique of Patent Document 1, an electrode need not be attached to a semiconductor thin film, and the mobility of the semiconductor thin film can be measured in a short time and with high accuracy. However, in Patent Document 1, the stress stability cannot be evaluated. Therefore, the stress evaluation has been still evaluated by NBTI (Negative Bias Temperature Instability) test, etc. requiring electrode attachment.

In turn, separate devices are needed for evaluating the mobility and the stress stability of an oxide semiconductor thin film. Such a situation not only greatly affects the productivity but also has a problem that since a plurality of devices must be prepared, the production cost rises.

The present invention has been made by taking into account these circumstances, and an object thereof is to provide an evaluation device ensuring that the mobility and stress stability as electrical properties of an oxide semiconductor thin film can be contactlessly, accurately and conveniently measured by single device and the evaluation of electrical properties, including prediction and estimation, can be thereby performed.

### MEANS FOR SOLVING THE PROBLEMS

The evaluation device for an oxide semiconductor thin film of the present invention is defined by claim 1.

In the present invention, it is preferred that the first excitation light irradiation unit has a light source that outputs energy equal to or more than a bandgap of the oxide semiconductor thin film. It is also a preferred embodiment that the second excitation
light irradiation unit has a light source that outputs energy equivalent to a defect state present in the bandgap of the oxide semiconductor thin film.

In addition, it is also preferred that the second excitation light irradiation unit has a light source that outputs energy to excite only photoluminescence light having a predetermined wavelength in the oxide semiconductor thin film.

Furthermore, in the present invention, it is also preferred that an optical path switching unit configured to switch an optical path of the first excitation light and/or the second excitation light is arranged on the optical path of the first excitation light and the second excitation light. It is also preferred that the optical path switching unit is disposed so that identical or different measurement regions of the sample are irradiated with the first and the second excitation lights.

In carrying out the present invention, it is also a preferred embodiment that a waveguide configured to guide the first excitation light and the electromagnetic wave to the measurement region of the sample is arranged, and an inlet port for the second excitation light is disposed on a side face of the waveguide at the vicinity of an opening of the waveguide toward the sample.

### ADVANTAGE OF THE INVENTION

According to the present invention, a device for contactlessly, accurately and conveniently predicting, estimating and evaluating the mobility and stress stability of an oxide semiconductor thin film can be provided. In particular, according to the present invention, the mobility and the stress stability can be evaluated by the same device.

Therefore, as compared with a conventional case requiring separate evaluation devices for the evaluations of mobility and stress stability of an oxide semiconductor, the evaluation device installation cost can be reduced and the evaluation device installation space can be saved.

When the device of the present invention is used, electrical properties of an oxide semiconductor thin film can be contactlessly performed in-line in a short time in the production line of a liquid display device, etc., so that enhancement of the productivity, such as enhancement of the yield, can be achieved and the quality control of an oxide semiconductor can be appropriately performed.

### BRIEF DESCRIPTION OF THE DRAWINGS

[FIG. 1] FIG. 1 is a schematic explanatory diagram illustrating an example of the evaluation device of the present invention.
[FIG. 2] FIG. 2 is a schematic explanatory diagram illustrating another example of the evaluation device of the present invention.
[FIG. 3] FIG. 3 is a schematic explanatory diagram illustrating still another example of the evaluation device of the present invention.
[FIG. 4] FIG. 4 is a schematic explanatory diagram regarding collection of photoluminescence light by using an ellipsoid mirror.
[FIG. 5] FIG. 5 is a schematic explanatory diagram of a waveguide in which a second excitation light inlet port is disposed at the vicinity of an opening at a distal end of the waveguide.

### MODE FOR CARRYING OUT THE INVENTION

As described above, the present applicant previously proposed an evaluation method by a microwave photoconductivity decay method as a technique for evaluating the mobility of an oxide semiconductor thin film. The evaluation method by a microwave photoconductivity decay method is contactless-type measurement requiring no electrode attachment and moreover, the measurement can be performed in a short time. Therefore, also in the present invention, the mobility is evaluated by a known microwave photoconductivity decay method.

On the other hand, the stress stability cannot be evaluated by the technique that was proposed previously, and in view of this, the present inventors had made many intensive studies on the technique for the evaluation of stress stability. As a result, it had been found to be effective to measure, as an indicator for contactlessly and conveniently evaluating (predicting and estimating) the stress stability of an oxide semiconductor thin film, the emission intensity of photoluminescence light exited when a sample having formed thereon an oxide semiconductor thin film is irradiated with exciting light. The present inventors had studied thereon, as a result, it was discovered that the emission intensity, preferably the peak intensity, of photoluminescence light has a substantially good correlation with ΔVth. More specifically, it was found that there is a tendency that when the emission intensity (hereinafter, inclusive of the peak intensity as a preferred embodiment) of the photoluminescence light is increased, ΔVth also increases and the stress stability decreases. Accordingly, the superiority and inferiority, for example, the pass/fail judgment, of the stress stability of an oxide semiconductor thin film can be almost completely grasped according to the measurement results of emission intensity of the photoluminescence light.

Based on this finding, the configuration of the device capable of evaluating the mobility and the stress stability had been studied and as a result, it had been found that there are ones overlapping with each other among configurations necessary for the evaluation of mobility and configurations necessary for the evaluation of stress stability. Many studies were further made, and by partially modifying a conventional mobility evaluation device, a configuration necessary for the evaluation of stress stability was provided to the mobility evaluation device, whereby not only the mobility but also the stress stability could be evaluated by the same device.

The modes for carrying out the present invention are described in detail below by referring to the drawings. However, the evaluation device of the present invention is not limited to the following configurations, and appropriate changes can also be made therein.

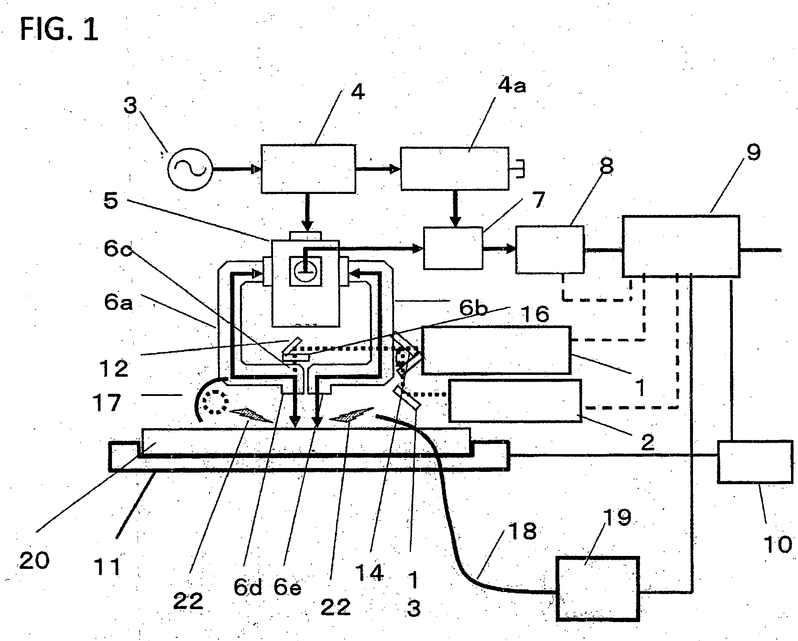

FIG. 1 is a schematic explanatory diagram illustrating an example of the evaluation device used for the evaluation of mobility and stress stability of an oxide semiconductor thin film. The evaluation device illustrated in FIG. 1 includes a first excitation light irradiation unit 1 such as pulsed laser for irradiating the measurement region of a sample 20 consisting of an oxide semiconductor thin film and a substrate with first excitation light, an electromagnetic wave irradiation unit 3 such as a microwave oscillator for the irradiation with a microwave (hereinafter, sometimes referred to as "electromagnetic wave"), and a reflecting electromagnetic wave intensity detection unit 7 such as a mixer for detecting the intensity of the microwave being reflected from the sample 20 and being varied by way of the irradiation with the first excitation light, and the mobility can be measured by this configuration. In addition, there are included a second excitation light irradiation unit 2 such as pulsed laser or CW laser for irradiating the measurement region the identical to or different from the electromagnetic wave intensity measurement region of the sample 20 with second excitation light, and an emission intensity measurement unit 19 for measuring the emission intensity of photoluminescence light generated by the irradiation with the second excitation light, and the stress stability can be measured by this configuration. Furthermore, there is included an evaluation unit 9 for evaluating the mobility and stress stability of the sample according to the detection data of the reflected electromagnetic wave intensity and the measurement data of the emission intensity.

The device configuration in the case of evaluating the mobility is described below by referring to FIG. 1. Details of the method for measuring the mobility are disclosed in JP-A-2012-033857; which may be referred to.

The device configuration for evaluating the mobility includes, out of the configuration illustrated in FIG. 1, the first excitation light irradiation unit 1, the electromagnetic wave irradiation unit 3, the reflecting electromagnetic wave intensity detection unit 7, and the evaluation unit 9, and in addition, as a preferable configuration, includes a directional coupler 4, a phase adjuster 4a, a magic T (5), a first waveguide-6a as a signal waveguide, a second waveguide-6b as a reference waveguide, a signal processing device 8, a stage controller 10, an X-Y stage 11, a sample support (not shown), a substrate holding part (not shown), optical path changing unit 12 such as a mirror, and a light collecting unit 16 such as a condensing lens.

The sample 20 consists of a substrate composed of glass, etc. and an oxide semiconductor thin film formed on a side of the substrate surface which is subjected to the excitation light. The kind of the oxide semiconductor is not particularly limited, and use can be made of, for example, an amorphous oxide semiconductor composed of a combination of at least one or more members selected from the group consisting of In, Ga, Zn, and Sn. The oxide semiconductor includes, for example, In oxide, In-Sn oxide, In-Zn oxide, In-Sn-Zn oxide, In-Ga oxide, Zn-Ga oxide, In-Ga-Zn oxide, and Zn oxide. The thin film of the oxide semiconductor may have a thickness of, for example, approximately from tens of nm to 100 nm.

For the substrate, various substrates can be used and, for example, a glass substrate for a liquid crystal display device having a thickness of about 0.7 mm and a size referred to as first to tenth generation, i.e., from tens of cm² to more than a few m², may be used.

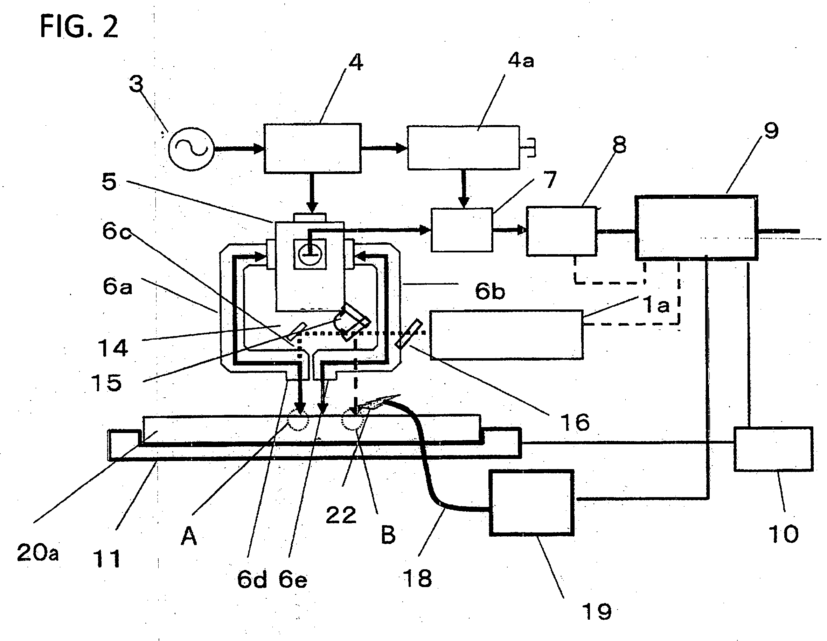

The sample 20 may have a portion A where the oxide semiconductor thin film is formed directly on the substrate, and a portion B where a metal film such as molybdenum is formed on the substrate and the oxide semiconductor thin film is formed thereon. The sample having such portions A and B is referred to as a sample 20a. In the portion A of the sample 20a, the oxide semiconductor thin film is formed directly on the substrate, so that reflection of a microwave can be prevented and the mobility can be sensitively measured. In the portion B of the sample 20a, production of luminescence light from the substrate can be avoided when the sample is irradiated with excitation light, and therefore, accuracy in the evaluation of stress stability is more increased. In the case of using such a sample, for example, an optical path switching unit 15 described later in FIG. 2 is used, whereby the measurement region of the sample can be irradiated with excitation light according to evaluations of the mobility indicated by the portion A in the figure or the stress stability indicated by the portion B in the figure.

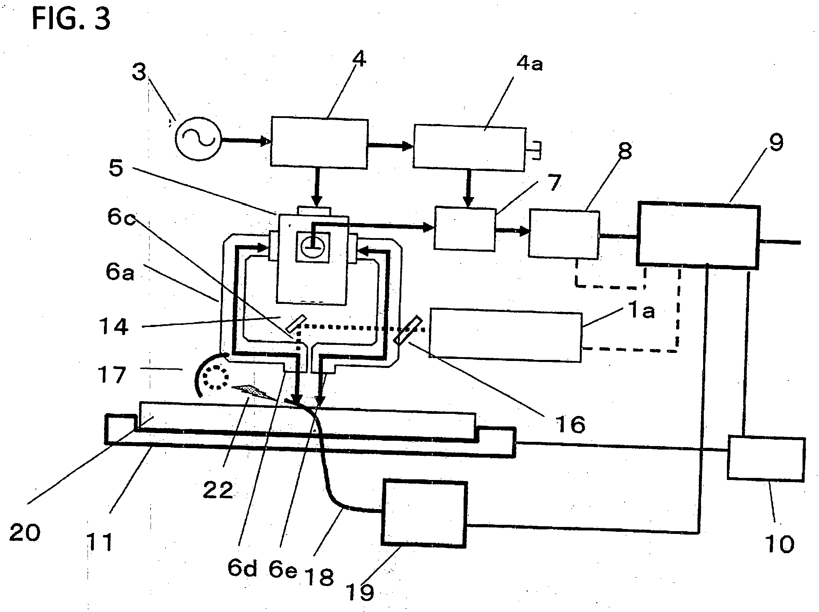

In the case where emission of luminescence light from the substrate is small to such an extent as not affecting the evaluation of stress stability of the oxide semiconductor thin film, a sample obtained by forming only the oxide semiconductor thin film directly on the substrate may be used. In the case of using such a sample 20, as described, for example, in FIG. 1 or FIG. 3, the identical region as the measurement region of the first excitation light for evaluating the mobility can be irradiated with the second excitation light for evaluating the stress stability. This is preferred because the mobility and stress stability in the identical region can be evaluated by irradiating the identical region with the first and second excitation lights.

The first excitation light irradiation unit 1 has a light source that outputs the first excitation light for irradiating the sample 20 and produces an electron-hole pair in the oxide semiconductor thin film by the irradiation with the first excitation light. It preferably has a light source that outputs excitation light having energy equal to or larger than the bandgap of the oxide semiconductor thin film. It is preferred because, by outputting energy equal to or larger than the bandgap of the oxide semiconductor thin film, a carrier can be efficiently generated and measurement can be performed with high sensitivity. As to the first excitation light irradiation unit for outputting energy equal to or larger than the band gap, for example, an ultraviolet laser may be used for the light source. Specifically, the laser includes a semiconductor laser such as pulsed laser launching, as excitation light, YLF laser third harmonic wave, etc. that is pulsed ultraviolet light having a wavelength of 349 nm, a power of 1 µJ/pulse, a pulse width of about 15 ns, and a beam diameter of about 1.5 mm.

The first excitation light irradiation unit 1 is triggered by an input of a timing signal transmitted from the evaluation unit 9 as illustrated by a dashed line in the figure to output pulsed light that is the first excitation light. The timing signal is simultaneously transmitted also to the signal processing device 8.

The first excitation light output from the first excitation light irradiation unit 1 is reflected, for example; by optical path changing unit (hereinafter, represented by a mirror) 12 such as mirror and at the same time, is collected by light collecting unit (hereinafter, represented by condensing lens) 16 such as condensing lens, passes through a fine aperture 6c provided in the first waveguide 6a, and irradiates the measurement region of the sample 20, for example, a spot with a diameter of approximately from 5 to 10 µm, via an opening 6d at the end of the first waveguide 6a in proximity to the sample 20. In this way, the mirror 12 and the condensing lens 16 collect the first excitation light output from the first excitation light irradiation unit 1 and guide it to the measurement region of the sample 20. Thereby an excited carrier is generated in the measurement region, i.e., a fine excitation light irradiation region in the sample 20.

The electromagnetic wave irradiation unit 3 outputs microwave, that is a kind of electromagnetic waves to irradiate a measurement region including a region excited by the first excitation light in the sample 20. An example of the electromagnetic irradiation unit 3 is a microwave oscillator such as Gunn diode having a frequency of 26 GHz.

The directional coupler 4 makes the microwave output from the electromagnetic wave irradiation unit 3 branched into two. One output wave (hereinafter, referred to as first microwave Op1) after branching is transmitted to the magic T (5) side, and the other output wave (hereinafter, referred to as second microwave Op2) is transmitted to the phase adjuster 4a and the LO input end of the reflecting electromagnetic wave intensity detection unit 7. As the directional coupler 4, for example, a 10dB coupler is employed.

The magic T (5) makes the first microwave Op1 branched into two and, as for the first microwave branched into two directions, the magic T (5) outputs a difference signal Rt1 (hereinafter, referred to as reflected wave difference signal) and a sum signal of respective reflected wave signals in regard to the sample 20.

One wave (hereinafter referred to as first primary microwave Op11) of the first microwave Op1 branched into two by the magic T (5) is guided by a first waveguide 6a connected to the magic T (5), to a portion including the excitation part that is the measurement region of the sample 20, and radiated from an opening 6d at the distal end of the waveguide. Thereby the measurement region of the sample 20 is irradiated with the first primary microwave Op11. Furthermore, the first waveguide 6a fulfills a function of capturing, at the distal end opening 6d, a reflected wave of the first primary microwave Op11 irradiating the measurement region, and guiding it to turn back and sail up to the magic T (5), in addition to the function as a waveguide antenna for radiating the first primary microwave Op 11.

On the other hand, the other wave (hereinafter referred to as first secondary microwave Op12) of the first microwave Op1 branched into two by the magic T (5) is guided by the second waveguide 6b connected to the magic T (5), to the vicinity of the measurement region of the sample 20a, i.e., a portion not including the excitation part with excitation light, and radiated from the opening 6e at the distal end of the waveguide. Thereby the first secondary microwave Op12 irradiates the vicinity of the measurement region of the sample 20a. Furthermore, the second waveguide 6b fulfills a function of capturing, at the distal end opening 6e, a reflected wave of the first secondary microwave Op 12 irradiating the vicinity of the measurement region, and guiding it to turn back to the magic T (5), in addition to the function as a waveguide antenna for radiating the first secondary microwave Op12. Here, the path length for which the first waveguide 6a guides the microwave, and the path length for which the second waveguide 6b guides the microwave, are the same path length and are equal.

The reflected wave difference signal Rt1 that is a difference signal between two reflected waves guided to the magic T (5) by the first waveguide 6a and the second waveguide 6b, that is, between waves produced when each of first microwaves Op11 and Op12 after being branched into two is reflected on the sample 20, is output by the magic T (5) and transmitted to an RF input end of the reflecting electromagnetic wave intensity detection unit 7.

The reflecting electromagnetic wave intensity detection unit 7 outputs a wave detection signal Sg1 by mixing the second microwave Op2 and the reflected wave difference signal Rt1. The wave detection signal Sg1 is a signal indicating one example of the intensity of the reflected wave difference signal Rt1, for example, the intensity of reflected wave of the first microwave Op1 irradiating the sample 20, and is fetched by a signal processing device 8. The intensity of the reflected wave difference signal Rt1 changes in response to excitation light irradiation of the sample 20 held at a predetermined position by a substrate holding part (not shown). In this way, the reflecting electromagnetic wave intensity detection unit 7 detects the intensity of the reflected wave difference signal Rt1. As the reflecting electromagnetic wave intensity detection unit 7, there may be provided a mixer, or a microwave detector or (a wave detector) for inputting a microwave and outputting an electrical signal of current, voltage, etc. according to the intensity.

The intensity of the reflected wave difference signal Rt1 detected by the reflecting electromagnetic wave intensity detection unit 7 is varied by way of the irradiation of the first excitation light at the measurement region of the sample 20. Specifically, the intensity of the reflected wave difference signal Rt1 is temporarily increased by the irradiation with (pulsed light) corresponding to the first excitation light and thereafter decays. In addition, as the number of impurities, defects, etc. in the measurement region is larger, the intensity of the reflected wave difference signal Rt1 has a smaller peak value and the decay time (carrier lifetime) thereof becomes shorter.

With respect to the intensity of the reflected wave difference signal Rt1, which are varied by way of the irradiation with the first excitation light (pulsed light), the peak value thereof or the period (decay time: lifetime value) between the peak occurrence and decay to a predetermined level are index values for evaluating the mobility of the sample 20.

The signal processing device 8 is a device for detecting a peak value Sp of the change in the intensity of the reflected wave difference signal Rt1 detected by the reflecting electromagnetic wave intensity detection unit 7 and transmitting the detection result to the evaluation unit 9. More specifically, the signal processing device 8 is triggered by an input of a timing signal from the evaluation unit 9 to monitor the change in the reflected wave difference signal Rt1 for a given time, and the maximum value of the level of the reflected wave difference signal Rt1 obtained during that period is detected as a peak value Sp of the change in the intensity of the reflected wave difference signal Rt1. Here, the signal processing device 8 has a delay circuit for applying a delay processing to the reflected wave difference signal Rt1, sequentially detecting the signal intensity at a predetermined sampling frequency relative to the signal after the delay processing, and detecting a peak value Sp of the change in the intensity of the reflected wave difference signal Rt1 from the change in the detected value.

As for the evaluation unit 9, use can be made of a computer equipped with CPU, a memory part, an interface for input/output signal, etc., where CPU runs a predetermined program and various processings are thereby executed.

For example, the evaluation unit 9 outputs a timing signal indicating the output timing of excitation light to the first excitation light irradiation unit 1 and-the signal processing device 8 and at the same time, fetches a peak value Sp of the reflected wave difference signal Rt1 detected by the signal processing device 8, which is recorded in a memory part provided in the evaluation unit 9. The reflected wave difference signal Rt1 recorded, coming under the detection data, is used for the evaluation of carrier mobility of the sample 20.

The stage controller 10 controls the X-Y stage 11 according to a command from the evaluation unit 9 and thereby controls positioning of the measurement region in the sample 20.

A sample support (not shown) is provided on the upper side of the X-Y stage 11. The sample support is a plate-like member (hereinafter, sometimes referred to as "conductor member") composed of a metal such as aluminum, stainless steel or iron, or other conductors. A substrate holding part (not shown) is provided on the upper side thereof, and a sample 20 is placed on the substrate holding part. The sample support is thus arranged on the lower side of the sample 20, which is opposite to the side the sample 20 irradiated with the first microwaves Op11 and Op12.

The substrate holding part is a solid dielectric fixed to the upper side of the sample support. The substrate holding part is a solid dielectric inserted between the substrate as a sample and the sample support as a conductor member, and the material thereof is, for example, a dielectric having a relatively large refractive index, such as glass and ceramic. Thereby the wavelength of a microwave using the substrate holding part as a medium becomes short, and a thinner and lightweight material can be employed as the substrate holding part.

According to the configuration for evaluating the mobility of the present invention as above, while a photo-excited carrier is produced in the oxide semiconductor thin film by an action of the first excitation light emitted from the first excitation light irradiation unit 1, the photo-excited carrier moves in an electric field of the microwave emitted from the electromagnetic wave irradiation unit 3, and the state of the movement is affected by the presence of impurity, defect, etc. in the semiconductor. Therefore, the intensity of the reflected of microwave from the sample is detected by the reflecting electromagnetic wave intensity detection unit 7 and analyzed by the evaluation unit 9, whereby the mobility can be evaluated. In particular, the mobility can be evaluated by a value when the intensity of the reflected microwave becomes a peak. Here, the evaluation unit 9 controls the position of the stage consisting of an X-Y table 11, etc., so that a mapping measurement for judging the crystallinity in a predetermined area can also be performed.

Next, the device configuration in the case of evaluating the stress stability is described by referring to FIG. 1. The device configuration for evaluating the stress stability is composed of, out of the configuration illustrated in FIG. 1, the second excitation light irradiation unit 2, the emission intensity measurement unit 19, and the evaluation unit 9 for stress stability. In addition, as a preferable configuration, there are included an optical guidepath 18, the stage controller 10, the X-Y stage 11, a sample support (not shown), a substrate holding part (not shown), optical path changing units 12, 13 and 14, such as mirrors, and the condensing lens 16. The optical path changing units are preferably movable because the optical path can be changed to a desired angle. Here, as for those to which the same numbers as in the device configuration for the mobility are assigned, descriptions are sometimes omitted.

The second excitation light irradiation unit 2 has a light source outputting second excitation light for irradiating the sample 20 and generates photoluminescence light in an oxide semiconductor thin film by the irradiation with the second excitation light. It preferably has a light source that outputs energy equivalent to a defect state present in the bandgap of the oxide semiconductor thin film. By outputting energy equivalent to a defect state present in the bandgap of the oxide semiconductor thin film, the defect state in the bandgap, participating in luminescence, can be observed. It is also preferable to have a light source that outputs energy to excite only photoluminescence light having a predetermined wavelength, for example, of 1.6 to 1.9 eV in the oxide semiconductor thin film. This is because the emission intensity observed in the range of 1.6 to 1.9 eV has a substantially good correlation with ΔVth and is suitable for the evaluation of stress stability.

As to the second excitation light irradiation unit, for example, an ultraviolet laser may be used for the light source. Specifically, it is preferable to use, for example, a semiconductor laser launching, as excitation light, YLF laser third harmonic wave, etc. that is pulsed ultraviolet light having a wavelength of 349 nm, a pulsed laser power of 1 µJ/pulse, a pulse width of about 15 ns, and a beam diameter of about 1.5 mm. In addition, a He-Cd laser, an argon ion laser, etc. may also be used as a laser light source capable of irradiating with continuous light.

In the case where the second excitation light irradiation unit 2 is a pulsed laser, it is triggered by an input of a timing signal transmitted from the evaluation unit 9 as illustrated by a dashed line in the figure to output pulsed light that is the second excitation light. On other hand, in the case of laser capable of generating continuous light, an ON signal such as high of TTL is, for example, transmitted from the evaluation unit 9 to output the laser for a required period, for example, from 100 mS to several seconds.

The second excitation light emitted from the second excitation light irradiation unit 2 follows the same optical path as that of the first excitation light to irradiate the sample 20. In the optical path, a condensing lens 16 is preferably provided, and luminescence light generated can thereby be efficiently collected. In the example illustrated, the second excitation light output from the second excitation light irradiation unit 2 is reflected in sequence by the mirrors 13,14 and 12, collected by the condensing lens 16, passes through a fine aperture 6c provided in the first waveguide 6a, and irradiates the identical measurement region of the sample 20 as that of the first excitation light via an opening 6d at the end of the first waveguide 6a in proximity to the sample 20. Thereby photoluminescence light is excited in the measurement region, i.e., a fine excitation light irradiation region in the sample 20. In this way, the identical measurement region as that of the first excitation light is irradiated with the second excitation light, so that the mobility and reliability at the identical measurement region can be evaluated.

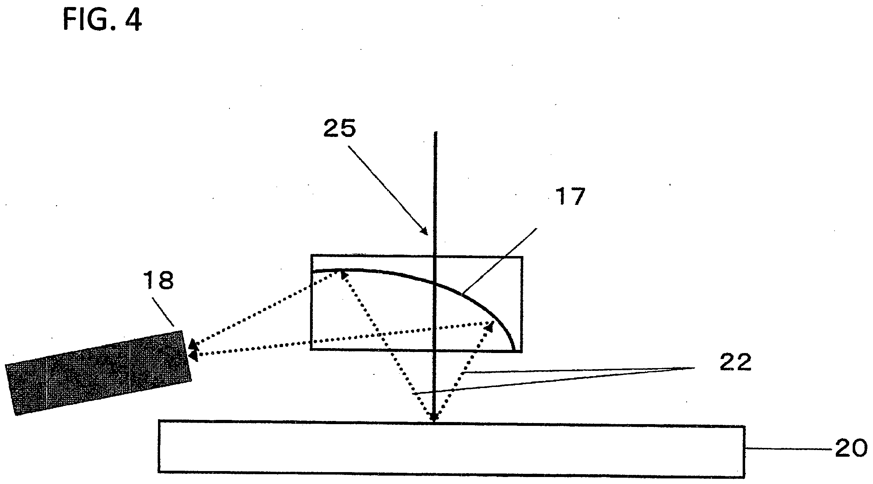

The photoluminescence light generated in the measurement region of the sample 20 by irradiation with the second excitation light is captured at the distal end opening of the optical guidepath 18 and guided to the emission intensity measurement unit 19. Here, it is preferred to provide a mirror 17 having an ellipsoid surface in the vicinity of the measurement region of the sample 20 because scattered photoluminescence light can be reflected by the ellipsoid mirror 17 and converged to the reflected focus. In addition, it is preferred, as illustrated in FIG. 4, to provide an incident port of the optical guidepath 18 on the reflected focus of the ellipsoid mirror 17 because light can be efficiently collected. The optical guidepath 18 may be sufficient if the collected photoluminescence light can be guided to the emission intensity measurement unit 19 with low loss. Examples thereof include an optical fiber.

The photoluminescence light guided to the emission intensity measurement unit 19 is wavelength-resolved, and the emission intensity of each spectrum is recorded. The emission intensity measurement unit 19 preferably has a function of measuring all spectra over the visible region, for example, by means of a spectroscope and extracting therefrom a peak intensity observed in the range of 1.6 to 1.9 eV. The emission intensity measurement unit 19 may also be used by combining a spectroscope, photodetection unit such as Charge Coupled Device (CCD), photomultiplier tube or light receiving element, and a filter capable of selectively transmitting only light of 1.6 to 1.9 eV. In addition, the emission intensity measurement unit 19 is preferably equipped with a trigger for performing the measurement in response to the irradiation time with excitation light. Based on a trigger signal transmitted to the laser from the evaluation unit 9, the emission intensity measurement unit 19 performs the intensity measurement only during the time exposed to a laser, whereby the measurement can be performed with high sensitivity.

Various measurement data processed in the emission intensity measurement unit 19 are transmitted to the evaluation unit 9. In the evaluation unit 9, a waveform analysis is performed by fetching the divided spectrum as measurement data, and the emission intensity ratio at a set energy is calculated. The evaluation unit 9 outputs a timing signal indicating the output timing of excitation light to the second excitation light irradiation unit 2 as well as records an intensity value of the spectrum output from the emission intensity measurement unit 19, in a memory part provided in the evaluation unit, and in addition, calculates a peak intensity from a broad peak present in the range of 1.6 to 1.9 eV. The stress stability can be evaluated by using the obtained data.

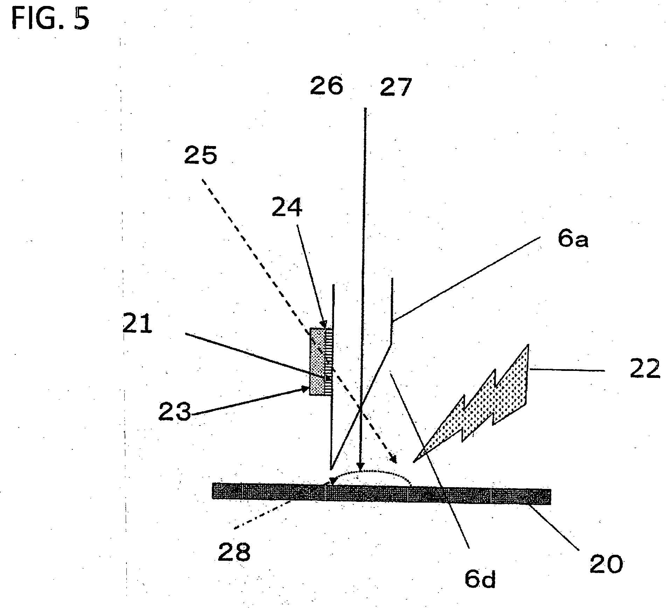

In the case where, as illustrated in FIG. 1, the identical measurement region of the sample 20 is irradiated with the first excitation light and the second excitation light, the optical path changing unit may be appropriately disposed so that, similarly to the first excitation light, the measurement region can be irradiated through the opening 6d on the sample 20 side from the fine opening 6c of the waveguide 6a guiding second excitation light to the measurement portion of the sample 20. As illustrated in FIG. 5, a second excitation light inlet port 21 composed of a transparent member such as glass may be provided on the side wall in the vicinity of the sample 20-side opening 6d of the first waveguide 6a. When the second excitation light is made incident from the second excitation light inlet port 21 by changing the optical path of the second excitation light and the second excitation light is launched from the opening 6d of the waveguide 6a, even in the case where the optical path is different, the measurement region of the first excitation light can be irradiated with the second excitation light. Here, a filter 24 for preventing microwave leakage, which is a filter for transmitting excitation light and not transmitting a microwave, is preferably provided at the second excitation light inlet port 21 so as to block the microwave leakage, and it is also preferable to cover the outside of the filter with a translucent member 23 having a property of transmitting excitation light, such as glass.

According to the device configuration for evaluating the stress stability of the present invention as above, photoluminescence light is generated in the oxide semiconductor thin film by an action of the second excitation light emitted from the second excitation light irradiation unit 2, and the emission intensity of the photoluminescence light 22 is analyzed by the emission intensity measurement unit 19 and further analyzed by the evaluation unit 9, whereby the stress stability can be evaluated. In particular, according to the device of the present invention, the identical measurement region of a sample can be irradiated with the first excitation light and the second excitation light, and the mobility and stress stability in the identical region of an oxide semiconductor thin film can be evaluated.

Other embodiments of the device of the present invention are described below by referring to FIG. 2 and FIG. 3. The same features as those in the device of FIG. 1 are assigned with the same number, and description thereof is emitted. FIG. 2 and FIG. 3 are an example using an excitation light irradiation unit 1a such as a pulsed laser having functions of both the first excitation light irradiation unit and the second excitation light irradiation unit. First excitation light for measuring the mobility and second excitation light for evaluating the stress stability can be emitted from the excitation light irradiation unit 1a. By sharing a common ultraviolet laser as the light source used for respective excitation light irradiations, cost reduction and simplification of the device configuration can be achieved. The excitation light irradiation unit 1a is preferably equipped with output adjusting unit so as to provide energy irradiation according to respective excitation lights.

In the case of emitting the first excitation light and the second excitation light from the same excitation light irradiation unit 1a, the optical path of the first excitation light and the optical path of the second excitation light may be the same, or an optical path switching unit 15 may be provided to switch the optical path of the first excitation light and/or the second excitation light to offer irradiation to different measurement regions of the sample 20a. For example, in FIG. 2, the first excitation light launched from the excitation light irradiation unit 1a is switched in the optical path thereof by the mirror 12 and caused to pass through a fine aperture 6c of the first waveguide 6a to the opening 6d, whereby the portion A that is the measurement region of the sample 20a is irradiated. The second excitation light output from the excitation light irradiation unit 1a is switched in the optical path thereof by the optical path switching unit 15, whereby the portion B that is a different measurement region of the sample 20a from that of first excitation light is irradiated. In FIG. 3, the first excitation light launched from the excitation light irradiation unit 1a is switched in the optical path thereof by the mirror 14, whereby the measurement region of the sample 20 is irradiated and similarly, the second excitation light follows the same optical path as that of the first excitation light, whereby the identical measurement region of the sample 20 is irradiated. Although not illustrated, it is also possible to appropriately arrange optical path switching unit and optical path changing unit such as mirrors and irradiate arbitrary portions with the first excitation light and the second excitation light.

The optical path switching unit 15 illustrated in FIG. 2 has a movable part and an optical path changing unit such as a mirror and can be moved by an electrical signal from the evaluation unit 9 to switch the optical path or block the optical path. In FIG. 2, the optical path switching unit 15 is fixed at a position not blocking the optical path during the first excitation light irradiation, and the optical path switching unit 15 can be moved to change the optical path of the second excitation light to a desired angle during the second excitation light irradiation. The power for moving the optical path switching unit 15 is not particularly limited, and known drive unit such as motor or pressure air can be employed.

When the device of the present invention as above is used, at the material development stage of an oxide semiconductor thin film, the mobility and stress stability of oxide semiconductor thin films having various compositions or concentrations can be conveniently evaluated in a short time at a low cost. In addition, when the device of the present invention is used, the evaluation can be contactlessly performed, so that enhancement of the productivity, such as enhancement of the yield, can be achieved and the quality control of an oxide semiconductor can be appropriately performed.

This application claims the benefit of priority based on Japanese Patent Application No. 2013-190402 filed on September 13, 2013.

### DESCRIPTION OF REFERENCE NUMERALS AND SIGNS

- 1: First excitation light irradiation unit (pulsed laser)
- 1a: Excitation light irradiation unit (pulsed laser)
- 2: Second excitation light irradiation unit (pulsed laser or CW laser)
- 3: Electromagnetic wave irradiation unit (microwave oscillator)
- 4: Directional coupler
- 4a: Phase adjuster
- 5: Magic T
- 6a: First waveguide (signal waveguide)
- 6b: Second waveguide (reference waveguide)
- 6c: Fine aperture (first waveguide)
- 6d: Opening (first waveguide)
- 6e: Opening (second waveguide)
- 7: Reflecting electromagnetic wave intensity detection unit (mixer)
- 8: Signal processing device
- 9: Evaluation unit
- 10: Stage controller
- 11: X-Y Stage
- 12: Optical path changing unit (mirror)
- 13: Optical path changing unit (mirror)
- 14: Optical path changing unit (mirror)
- 15: Optical path switching unit
- 16: Light collecting unit (condensing lens)
- 17: Ellipsoid mirror
- 18: Optical guidepath
- 19: Emission intensity measurement unit
- 20: Sample
- 20a: Sample
- 21: Second excitation light inlet port (glass)
- 22: Photoluminescence light
- 23: Translucent member
- 24: Filter for preventing microwave leakage
- 25: Second excitation light
- 26: First excitation light
- 27: Microwave
- 28: Measurement region

## Claims

1. An evaluation device for an oxide semiconductor thin film, comprising:
a first excitation light irradiation unit (1) configured to irradiate a first measurement region of a sample (20a) wherein an oxide semiconductor thin film is formed with first excitation light and to generate an electron-hole pair in the oxide semiconductor thin film;
an electromagnetic wave irradiation unit (3) configured to irradiate the first measurement region (A) of the sample with electromagnetic wave;
a reflecting electromagnetic wave intensity detection unit (7) configured to detect intensity of the electromagnetic wave being reflected from the sample and being varied by way of the irradiation with the first excitation light;
a second excitation light irradiation unit (2) configured to irradiate a second measurement region (B) of the sample (20a) with second excitation light (25) and to generate photoluminescence light (22) in the oxide semiconductor thin film; and
an emission intensity measurement unit (19) configured to measure emission intensity of the photoluminescence light; and
an evaluation unit (9) configured to evaluate carrier mobility and electrical stress stability of the sample according to data detected by the reflecting electromagnetic wave intensity detection unit and data measured by the emission intensity measurement unit, respectively,
wherein the first excitation light irradiation unit and the second excitation light irradiation unit are the same or different excitation light radiation units.

2. The evaluation device for an oxide semiconductor thin film according to Claim 1, wherein the first excitation light irradiation unit comprises a light source that outputs energy equal to or more than a bandgap of the oxide semiconductor thin film.

3. The evaluation device for an oxide semiconductor thin film according to any of Claims 1 and 2, wherein the second excitation light irradiation unit comprises a light source that outputs energy equivalent to a defect state present in the bandgap of the oxide semiconductor thin film.

4. The evaluation device for an oxide semiconductor thin film according to Claim 3, wherein the second excitation light irradiation unit comprises a light source that outputs energy to excite only photoluminescence light having a predetermined wavelength in the oxide semiconductor thin film.

5. The evaluation device for an oxide semiconductor thin film according to any one of Claims 1 to 4, comprising an optical path switching unit configured to switch one or both optical paths of the first and the second excitation lights, being arranged on the optical path of the first excitation light and the second excitation light.

6. The evaluation device for an oxide semiconductor thin film according to Claim 5, wherein the optical path switching unit is disposed so that an identical or different measurement regions of the sample are irradiated with the first and the second excitation lights.

7. The evaluation device for an oxide semiconductor thin film according to any one of Claims 1 to 4, comprising:
a waveguide configured to guide the first excitation light and the electromagnetic wave to the measurement region of the sample, and
an inlet port for the second excitation light disposed on a side face of the waveguide at the vicinity of an opening of the waveguide toward the sample.

## Patentansprüche

1. Auswerteeinrichtung für eine Oxidhalbleiterdünnschicht mit:
einer ersten Anregungslichtbestrahlungseinheit (1), die konfiguriert ist, ein erstes Messegebiet einer Probe (20a) in dem eine Oxidhalbleiterschicht gebildet ist, mit erstem Anregungslicht zu bestrahlen und ein Elektron-Loch-Paar in der Oxidhalbleiterdünnschicht zu erzeugen;
eine elektromagnetische Wellenbestrahlungseinheit (3), die konfiguriert ist, das erste Messgebiet (A) der Probe mit einer elektromagnetischen Welle zu bestrahlen;
einer Reflektierte-Elektromagnetische-Wellenintensitätserfassungseinheit (7), die konfiguriert ist, eine Intensität der elektromagnetischen Welle, die von der Probe reflektiert ist und durch die Bestrahlung mit dem ersten Anregungslicht variiert wurde, zu erfassen;
einer zweiten Anregungslichtbestrahlungseinheit (2), die konfiguriert ist, ein zweites Messgebiet (B) der Probe (20a) mit zweitem Anregungslicht (25) zu bestrahlen und Photolumineszenzlicht (22) in der Oxidhalbleiterdünnschicht zu erzeugen; und
einer Emissionsintensitätsmesseinheit (19), die konfiguriert ist, eine Emissionsintensität des Photolumineszenzlichts zu messen; und
einer Auswerteeinheit (9), die konfiguriert ist, eine Ladungsträgermobilität und eine elektrische Stressstabilität der Probe gemäß den durch die Reflektierte-Elektromagnetische-Wellenintensitätserfassungseinheit erfassten Daten beziehungsweise durch die Emissionsintensitätsmesseinheit gemessenen Daten zu evaluieren,
wobei die erste Anregungslichtbestrahlungseinheit und die zweite Anregungslichtbestrahlungseinheit dieselben oder verschiedene Anregungslichtbestrahlungseinheiten sind.

2. Auswerteeinrichtung für eine Oxidhalbleiterdünnschicht nach Anspruch 1, wobei die erste Anregungslichtbestrahlungseinheit eine Lichtquelle aufweist, die eine Energie ausgibt, die gleich oder größer als eine Bandlücke der Oxidhalbleiterdünnschicht ist.

3. Auswerteeinrichtung für eine Oxidhalbleiterdünnschicht nach einem der Ansprüche 1 und 2, wobei die zweite Anregungslichtbestrahlungseinheit eine Lichtquelle aufweist, die eine Energie ausgibt, die äquivalent zu einem Defektzustand, der in der Bandlücke der Oxidhalbleiterdünnschicht vorhanden ist, ausgibt.

4. Auswerteeinrichtung für eine Oxidhalbleiterdünnschicht nach Anspruch 3, wobei die zweite Anregungslichtbestrahlungseinheit eine Lichtquelle aufweist, die eine Energie ausgibt, um nur Photolumineszenzlicht mit einer vorbestimmten Wellenlänge in der Oxidhalbleiterdünnschicht auszugeben.

5. Auswerteeinrichtung für eine Oxidhalbleiterdünnschicht nach einem der Ansprüche 1 bis 4, mit einer optischen Pfadschalteinheit, die konfiguriert ist, einen oder beide optischen Pfade der ersten und der zweiten Anregungslichter zu schalten, und die auf dem optischen Pfad des ersten Anregungslichts und des zweiten Anregungslichts angeordnet ist.

6. Auswerteeinrichtung für eine Oxidhalbleiterdünnschicht nach Anspruch 5, wobei die optische Pfadschalteinheit so angeordnet ist, dass identische oder verschiedene Messgebiete der Probe mit den ersten und zweiten Anregungslichtern bestrahlt werden.

7. Auswerteeinrichtung für eine Oxidhalbleiterdünnschicht nach einem der Ansprüche 1 bis 4, mit:
einem Wellenleiter, der konfiguriert ist, das erste Anregungslicht und die elektromagnetische Welle zu dem Messgebiet der Probe zu leiten, und
einem Eingabeanschluss für das zweite Anregungslicht, der auf einer Seitenfläche des Wellenleiters in der Nähe einer Öffnung des Wellenleiters hin zu der Probe angeordnet ist.

## Revendications

1. Dispositif d'évaluation pour un film mince de semi-conducteur à oxyde, qui comprend :
une première unité de rayonnement de lumière d'excitation (1) configurée pour irradier une première région de mesure d'un échantillon (20a) dans laquelle un film mince de semi-conducteur à oxyde est formé par une première lumière d'excitation et pour générer une paire électron-trou dans le film mince de semi-conducteur à oxyde ;
une unité de rayonnement d'onde électromagnétique (3) configurée pour irradier la première région de mesure (A) de l'échantillon avec une onde électromagnétique ;
une unité de détection d'intensité d'onde électromagnétique de réflexion (7) configurée pour détecter l'intensité de l'onde électromagnétique réfléchie par l'échantillon et modifiée au moyen de l'irradiation avec la première lumière d'excitation ;
une deuxième unité de rayonnement de lumière d'excitation (2) configurée pour irradier une deuxième région de mesure (B) de l'échantillon (20a) avec une deuxième lumière d'excitation (25) et pour générer une lumière de photoluminescence (22) dans le film mince de semi-conducteur à oxyde ; et
une unité de mesure d'intensité d'émission (19) configurée pour mesurer l'intensité d'émission de la lumière de photoluminescence ; et
une unité d'évaluation (9) configurée pour évaluer la mobilité des porteurs et la stabilité de la contrainte électrique de l'échantillon conformément aux données détectées par l'unité de détection d'intensité d'onde électromagnétique de réflexion et aux données mesurées par l'unité de mesure d'intensité d'émission, respectivement,
dans lequel la première unité de rayonnement de lumière d'excitation et la deuxième unité de rayonnement de lumière d'excitation sont des unités de rayonnement de lumière d'excitation identiques ou différentes.

2. Dispositif d'évaluation pour un film mince de semi-conducteur à oxyde selon la revendication 1, dans lequel la première unité de rayonnement de lumière d'excitation comprend une source de lumière qui délivre une énergie supérieure ou égale à une bande interdite du film mince de semi-conducteur à oxyde.

3. Dispositif d'évaluation pour un film mince de semi-conducteur à oxyde selon l'une quelconque des revendications 1 et 2, dans lequel la deuxième unité de rayonnement de lumière d'excitation comprend une source de lumière qui délivre une énergie équivalente à un état de défaut présent dans la bande interdite du film mince de semi-conducteur à oxyde.

4. Dispositif d'évaluation pour un film mince de semi-conducteur à oxyde selon la revendication 3, dans lequel la deuxième unité de rayonnement de lumière d'excitation comprend une source de lumière qui délivre une énergie pour n'exciter que la lumière de photoluminescence présentant une longueur d'onde prédéterminée dans le film mince de semi-conducteur à oxyde.

5. Dispositif d'évaluation pour un film mince de semi-conducteur à oxyde selon l'une quelconque des revendications 1 à 4, qui comprend une unité de commutation de trajet optique configurée pour commuter l'un ou les deux trajets optiques des première et deuxième lumières d'excitation, agencée sur le trajet optique de la première lumière d'excitation et de la deuxième lumière d'excitation.

6. Dispositif d'évaluation pour un film mince de semi-conducteur à oxyde selon la revendication 5, dans lequel l'unité de commutation de trajet optique est disposée de sorte que des régions de mesure identiques ou différentes de l'échantillon soient irradiées par les première et deuxième lumières d'excitation.

7. Dispositif d'évaluation pour un film mince de semi-conducteur à oxyde selon l'une quelconque des revendications 1 à 4, qui comprend :
un guide d'ondes configuré pour guider la première lumière d'excitation et l'onde électromagnétique vers la région de mesure de l'échantillon, et
un port d'entrée pour la deuxième lumière d'excitation disposé sur une face latérale du guide d'ondes dans le voisinage d'une ouverture du guide d'ondes vers l'échantillon.
